# EUROPEAN PATENT SPECIFICATION

(11) **EP 3 271 622 B1**
(45) Date of publication and mention of the grant of the patent: **26.08.2020**
(21) Application number: 16722364.3
(22) Date of filing: 15.03.2016
(51) Int. Cl.: F16J 15/08, F16L 23/20

(54) **PROCESS FOR MANUFACTURING A VACUUM AND RADIO-FREQUENCY METAL GASKET AND STRUCTURE INCORPORATING IT**
VERFAHREN ZUR HERSTELLUNG EINER VAKUUM- UND HOCHFREQUENZ-METALLDICHTUNG UND STRUKTUR DAMIT
PROCÉDÉ DE FABRICATION D'UN JOINT D'ÉTANCHÉITÉ À VIDE ET À RADIO-FRÉQUENCE ET STRUCTURE COMPORTANT CELUI-CI

(30) Priority: 16.03.2015 IT UB20150570
(43) Date of publication of application: 24.01.2018
(73) Proprietor: Istituto Nazionale Di Fisica Nucleare (INFN), 00044 Frascati RM (IT)
(72) Inventor: ALESINI, David, 00044 Frascati (RM) (IT); LOLLO, Valerio, 00044 Frascati (RM) (IT); BATTISTI, Antonio, 00044 Frascati (RM) (IT)
(74) Representative: Leone, Mario
(86) International application number: PCT/IB2016/051464
(87) International publication number: WO 2016/147118

(56) References cited:
- WO-A1-93/18331
- FR-A- 1 583 060
- US-A- 2 307 440
- US-A- 4 303 251
- US-A1- 2013 001 443
- US-B1- 6 769 697

## Description

The present invention is related to a process for manufacturing a metal gasket allowing to keep a vacuum sealing between two metal portions connected therebetween at a joint, and at the same time it is able to guarantee between these portions an electrical continuity, required for implementing structures such as for example high range radio-frequency structures and/or structures with high figures of merit, comprising in particular wave guides or resonant cavities.

In these structures, assemblies of different metal portions are provided. For example, in a particle accelerator a wave guide is provided extending through the structure, implemented by the coupling of different head-to-head metal ducts.

The coupling is implemented so that, inside the ducts, a high vacuum or ultra high vacuum level (10⁻⁶ ÷ 10⁻⁸ Pa) is guaranteed, considering that the structure has to work under said vacuum conditions. The metals which are used in these contexts usually are metals with high electrical conductivity: copper, copper alloys, aluminium alloys and similar metallic materials with comparable mechanic and electrical features.

The magnetic fields which this type of structure can go across can be in the order of hundreds of kA/m.

In order to implement an adequate connection, generally one proceeds by implementing a welding or brazing, i.e. a procedure which gives good results if perfectly performed, but which has a not negligible percentage of failure in the implementation thereof and which in any case has very high costs as it requires vacuum ovens.

Furthermore, the annealing step provided in a brazing makes softer the metal materials of the joined portions and it alters the mechanical features and the structure performances when it works with high range gradient.

The US patent No. 6,769,697 B1 describes a metal gasket equipped with a tail with particular shape, which has the task of interrupting the gasket deformation during tightening. In such sealing system the gasket positioning depends upon the tolerances between a bolt and a hole obtained in a positioning plate of the gaskets, tolerances of some hundreds of µm, insufficient to implement precision and continuity of surfaces required for the requested radio-frequency and high range electrical continuity and/or with high figures of merit. It is further to be noted that the described gasket profile and the tightening interrupted upon reaching the tail surface thus determine the possible formation of air bags.

The US patent No. 4,303,251 A describes a metal gasket with a head and a tail, wherein the sealing is actually implemented in an intermediate portion between head and tail by causing, on one side, a discontinuity at the coupled surfaces and, on the other side, air bags which, in case of imperfections, could nullify the required high vacuum or ultra high vacuum. It is further to be noted that the positioning of the gasket in the compartment thereof depends upon the geometrical shape which couple and not upon the depth of the gasket itself: a possible extension of the gasket caused by the tightening could make the head position uncontrollable with respect to the coupled surfaces.

The international patent application No. WO 93/18331 A1 describes a metal gasket with complex shape, with two head and tail portions connected by an annular diaphragm. As in the previous document, the sealing is actually implemented in different intermediate portions between head and tail by causing, on one side, a discontinuity at the coupled surfaces and, on the other side, air bags which could nullify the required high vacuum or the ultra high vacuum. Furthermore, the positioning of the gasket in the department thereof depends upon the geometric shapes which couple and not upon the depth of the gasket itself: a possible extension of the gasket caused by the tightening would make uncontrollable the head position with respect to the coupled surfaces.

The French patent No. 1,583,060 A describes a metal gasket intended to be received in a department between the members to be coupled wherein the compartment is far from the surface of the cavity wherein the vacuum is wished. Even in this implementation the positioning of the gasket in the department thereof depends upon the geometrical shapes which couple and not upon the depth of the gasket itself: a deformation of the gasket caused by the tightening would make uncontrollable the positioning thereof. Furthermore, the shape of the compartment and of the head determines the presence of air bags with the above-highlighted drawbacks.

The US patent application No. US 2013/0257044 A1 proposes, for the vacuum sealing between two bodies, a gasket having a section with mainly conical profile, intended to be subjected to a compression and a consequent deformation when trapped in the joint between the metal portions. The angle of opening of the cone is very wide, therefore the deformation can be even accentuated and projecting from the base of the cone directed towards the under vacuum environment.

Projecting teeth are then formed exactly at the surface delimiting the under vacuum environment which, if one wishes to use it in high-intensity radio-frequency structures, can cause wholly unwished electric discharges.

The Japanese patent application No. JP 2012/082891 describes instead a process for implementing a sealing using a metal gasket which is deformed by ribs and grooves suitably implemented at the joint area.

Such procedure, although it can guarantee the required vacuum sealing, determines unwished protuberances inside the under vacuum environment and it can cause air bags in the junction, which can nullify the required vacuum and reduce the high electro-magnetic range performances.

At last, the US patent Nr. 2,307,440 A describes a metal gasket with corrugated sheet, with corrugations which are tightened in a gasket compartment thus creating air bags and without a real control of the positioning of the gasket head.

The technical problem underlying the present invention is to provide a process for manufacturing a metal gasket allowing to obviate the drawbacks mentioned by referring to the known art.

The solution idea consists in manufacturing a gasket wherein the geometrical shape thereof and the sizes thereof with respect to the compartment which is going to receive it are so as to guarantee intrinsically a precise control of the positioning of the gasket head with respect to the surfaces which are to be coupled, so as to implement not only a high vacuum sealing without the risk of air bags opened in the space wherein a high vacuum or ultra high vacuum level is formed, but even a perfect electric continuity of the resulting surface.

Such problem is solved by a process for manufacturing a metal gasket allowing to keep a vacuum sealing between two metal portions connected therebetween at a joint, with a high vacuum or ultra high vacuum level, as defined in the enclosed claim 1.

The present invention further relates to a vacuum sealing metal gasket as defined in claim 11, and an under vacuum radio-frequency structure according to claim 15 comprising at least such a gasket, and then to the high and ultra high vacuum sealing system comprising it, as defined in claim 17.

The main advantage of the process according to the present invention lies in the fact of allowing a ultra high vacuum sealing without air bags trapped between the gasket and the connected portions, and at the same time by implementing an electric continuity at the joint which does not produce any stress or discharges if subjected to radio-frequencies even with high intensity.

The present invention will be described hereinafter according to a preferred embodiment thereof, provided by way of example and not with limitative purposes by referring to the enclosed drawings wherein:
* figure 1 shows a plan and section gasket apt to be used in the process according to the invention;
* figure 2 illustrates a step for centering and a step for tightening the gasket of figure 1 in the process according to the invention;
* figure 3 illustrates the result of different centering and tightening steps performed by referring to figure 2; and
* figure 4 shows a cross-section of a radio-frequency structure implemented with gaskets obtained with the process according to the invention.

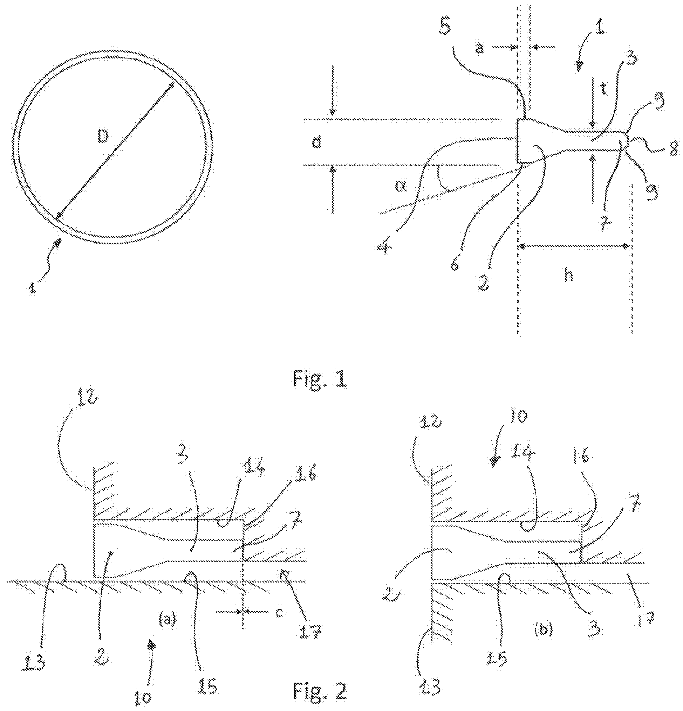

By referring to figure 1, a gasket is designated as a whole with 1. In the present example such gasket 1 has an annular and circular development with diameter D, being intended to guarantee a vacuum sealing between two head-to-head assembled ducts with circular section; however, one understands easily that such gasket can have any development, for example squared, rectangular, polygonal, ellipsoidal, linear and so on.

The gasket 1 comprises a cross-section, that is taken according to a plane perpendicular to the its own linear development, having a sealing head 2, substantially with conical shape, and a centering tail 3.

The gasket is made of metallic material, and advantageously it can be made of the same material thereof the portions are made which will have to be connected by the sealing gasket, then for example, copper, copper alloys, aluminium, aluminium alloys and/or materials with similar hardness. Upon implementing the present invention and for obtaining the required performances of vacuum sealing and radio-frequency contact it is not needed to come to the conditions of a plastic deformation of the gasket.

The head 2 and the tail 3 constitute a single body, without discontinuity, so that the gasket 1 is constituted in a single piece.

The head 2 has a flat base 4 constituting the inner face of the gasket 1 and then which is faced towards the environment to be kept under vacuum. Such face is intended to be aligned with the approached surfaces of the connected metal portions, to guarantee the greater surface continuity as much as possible.

The conical body constituting the head 2 has then upper 5 and lower 6 edges, which are adjacent to said flat base 4, being intended to be tightened between the two metal portions. Such edges have a flat resting surface, substantially perpendicular to said base 4, to guarantee the best contact quality as much as possible. Therefore, the two edges constitute two annular surfaces with prefixed width (a) developing for the whole circumference of the gasket 1. This guarantees that the sealing is actually implemented exactly at the flat base 4 of the gasket and not in an intermediate point between it and the tail 3.

The distance between the upper 5 and lower 6 edges represents the height (d) of the gasket 1, which is substantially constant on the whole longitudinal development thereof, except manufacturing errors provided in this type of productions.

The conical shape of the head 2 is characterized by an angular opening equal to 2α, wherein α is the half-opening of the cone designated in figure 1.

In the present embodiment example, such angular opening is lower than 60° with each opening not exceeding 30°.

In a herein described preferred solution of the gasket, each half-opening falls in the range comprised between 10° and 30°, with an overall opening comprised between 20° e 60°.

The centering tail 3 extends from a vertex of said head 2, in particular the vertex opposite to the flat base 4 of the gasket 1. The tail 3 extends towards outside according to a radial direction perpendicular with respect to said base 4 for a predetermined extension. It has a substantially constant thickness (t).

The tail 3 has a distal end 7 having a resting surface 8 substantially parallel to the base 4 of the sealing head 2, which is suitable to be rested upon the bottom of a gasket compartment suitably implemented between the metal portions which are sealingly connected thanks to the present gasket 1. At the edges, the resting surface has flares 9 to avoid the presence of sharp edges.

In this way, said resting surface 8 extends over the whole annular development of the gasket 1, and then it constitutes the outer face thereof.

The sum of the radial extensions of the head 2 and of the tail 3, that is the radial distance between the flat base 4 and the resting surface 8, constitutes the width (h) of the gasket, which is substantially constant on the whole longitudinal development.

In the herein described process, a gasket compartment 10 is arranged at the surfaces of the two metal portions 12, 13 to be connected and tightened therebetween, surfaces which delimit the environment to be kept under vacuum.

This gasket compartment 10 has a prefixed radial depth, which is substantially constant on the whole longitudinal development.

In the process, as well as in the sealing system according to the invention, such depth corresponds to the width of the gasket 1 as defined previously.

The compartment 10 further has a pair of tightening surfaces 14, 15 faced therebetween, intended to compress therebetween the gasket 1, and a bottom 16 thereupon the distal end 7 of the gasket 1 will rest.

At the bottom 16, the compartment 10 comprises a leakage 17 in at least a point of the circumference of the gasket, so as to prevent the formation of air bags.

When the gasket 1 is arranged inside the compartment 10, the tail 3 separates the compartment 10 in two areas, a lower and an upper one, at least one thereof is not involved by the leakage 17 and which then could constitute a not evacuated air bag near the ultra high vacuum environment. To obviate this, it is necessary to check that the areas of the compartment 10 separated from said tail 3 are in hydraulic communication therebetween, thanks to suitable discontinuities in the profile of said tail and/or in the surface of said compartment.

In the present example, such discontinuities are usually guaranteed by the manufacturing errors provided in the manufacturing of these mechanical organs. However, in order to avoid any air bag, it is possible implementing, at regular intervals, notches with reduced sizes at the distal end 7 of the gasket 1 and/or onto the bottom 16 of the gasket compartment 1.

Once provided the above-described gasket 1 and compartment 10, the process for implementing a sealing comprises a centering and tightening step.

In the centering step, the gasket 1 is arranged in said gasket compartment 10 by resting the distal end 7 of said tail 3 onto the bottom 16 of the compartment 10, and by verifying that the inner face 4 of the gasket 1 is flush with the surfaces of the metal portions to be joined.

By referring to figure 2, two possible cases are represented: (a) one wherein the connected portions are a a flat bottom one and a cylindrical one, and in such case it will be sufficient that said gasket face is flush with the single cylindrical surface only; and (b) one wherein the two connected portions are both cylindrical, in such case the gasket face will be flush with both cylindrical surfaces.

The centering will take place correctly if the overall width (h) of the gasket 1 will be substantially equal to the depth of the gasket compartment 10.

Once completed the centering step, one could proceed with the tightening step, wherein the two portions to be connected are tightened therebetween by using for example not represented calibrated bolts.

Therefore, the two metal portions are tightened one against the other one with growing tightening force, so as to implement the required sealing.

Alternatively, the surfaces 18 and 19 can be brought in contact by guaranteeing a compression level determined by the features of the compartment 10.

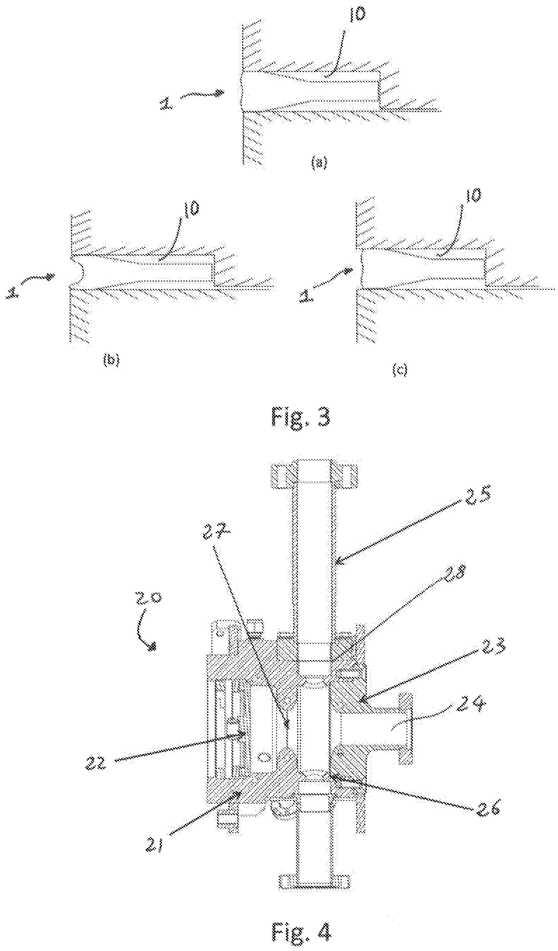

By referring to figure 3 (a), the tightening of the two portions involves that the sealing edges 5, 6 come in contact with the lower and upper faces of the gasket compartment 10. However, the tightening will be interrupted before giving the inner face of the gasket 1 a permanent deformation, that is so as to create a discontinuity between the connected surfaces.

To this purpose, the tightening will be so as to give an elastic deformation to the gasket 1, and not a plastic deformation, caused by an excessive tightening.

In this way, should the two metal portions be separate, the gasket 1 will come back to the original shape thereof.

By referring to figure 3, the case (b) is illustrated wherein the head 2 of the gasket is subjected to an excessive deformation: in this case the strong compression generates the presence of cracks, slots or tips on the surface of the gasket which weaken it from the mechanical point of view and which can generate discharges caused by radio-frequencies.

By referring to figure 3, the case (c) is at last illustrated wherein the centering does not result to be precise, and the gasket 1 has an inner face moved back with respect to the cylindrical surfaces forming the ultra high vacuum environment. In this case, the gasket 1 will function correctly, but there will be sharp edges which could cause unwished discharges.

In cases (b) and (c) represented in figure 3 the gasket will function for the vacuum sealing, but it cannot be used for radio-frequency structures.

It is to be meant that the above-described process could be applied to any type of vacuum connection wherein there are two metals which one wants to connect to a metal gasket made of the same metal or a metal with similar mechanical properties.

This type of gasket allows avoiding brazing processes by guaranteeing simultaneously an excellent sealing, with a leak rate lower than 10⁻⁸ Pa 1/s, even by subjecting the structure to heating processes, as well as a perfect radio-frequency contact between the metal portions which one wants to connect. In this sense, the factors of merit of the structures implemented according to the invention move away more than 5% with respect to those calculated by using numerical codes.
By referring to figure 4 a radio-frequency structure (RF) is described, in particular a RF gun designated with 20 used for the generation and the first acceleration of beams of electrons. Such structure is implemented with numerical control machines and high precision lathes therewith the various portions made of copper are manufactured, which are then brazed in vacuum ovens. It comprises a central body 21 which encompasses a removable cathode 22 and a closing plug 23 equipped with a duct allowing the passage of the accelerated electrons 24 (*Beam pipe*). The central body 21 is constituted by two cells implemented by a single block of copper and connected therebetween through an iris 27. Such cells are closed on one side by the cathode 22 made of copper and on the other side by the closing plug 23 made of copper. The structure is connected to a wave guide with rectangular section 25 connected to a klystron allowing the structure feeding. Such structures are typically fed with peak powers in the order of 7 ÷ 12 MW, by producing accelerating ranges in the order of 80 ÷ 120 MV/m on the cathode, with vacuum conditions in the order of 10⁻⁷ ÷ 10⁻⁸ Pa.

The gun, that is the electronic gun, was implemented with the process for tightening the metal gasket made of copper between the body 21 and the plug 23. Such gasket 28 has a circular profile. In the above-mentioned gun, by purely way of example, the gasket diameter D is 87.35 mm, it has a thickness d of 1.33 mm, a radial width (h) of 3.57 mm. The gasket resting annular surface has a width (a) of 0.2 mm and the angular width 2α is equal to 36.86° (α = 18.43°), the thickness (7) of the tail 3 is 0.73 mm.

The implemented structure was fed with peak powers in the order of 8 MW at frequency 2.856 GHz with accelerating ranges on the cathode in the order of 90 MV/m onto the cathode, under vacuum conditions in the order of 5x10⁻⁸ Pa.

It is to be noted that, in the preferential way, the width (a) of the resting surface could be increased to a maximum of 0.8 mm so as to guarantee the minimum compression of the gasket 1 and the localization of the radio-frequency contact by avoiding the formation of *microgaps* wherein the contact is not guaranteed.

In case, the resting surfaces could have an asymmetrical configuration, for example in case of asymmetrical connections (figure 2 (a)).

The height of the sealing tooth of the gasket 1, that is the distance between the tail 3 and the resting surfaces 5, 6 (that is the quantity (d-t)/2)) will be comprised between 0.2 mm and 0.4 mm.

The maximum centering error in the coupling between gasket and metal portions will have to be included between 20 µm and 40 µm, to avoid the formation of significant tips and edges in the gasket compartment 10. It is to be meant that this requirement is not strictly requested if the gasket has to provide only sealing (figure 3 (c)).

The gasket could be raw or partially annealed at a maximum temperature of 350°C; the advantage of the partial annealing is linked to the copper tenderizing which tends not to deform the adjacent surfaces, whereas annealings at higher temperatures can make the gasket to loose the required elasticity.

A compression of the gasket head comprised between 25% and 50% guarantees the required sealing and produces only an elastic deformation of the head. Under head compression, the compression of the sealing tooth is meant.

In the light of what previously described, the present invention relates a high and ultra high vacuum sealing system comprising two metal portions to be coupled, which form a space wherein a high or ultra high vacuum level is to be determined. Such space will be delimited by surfaces of said metal portions which are arranged so as to form a continuous surface.

They system then comprises a gasket compartment 10 formed between said metal portions at said continuous surface, having a section with a prefixed height and a depth.

At last, the sealing system comprises a metal gasket 1 as described previously, which is inserted between the two connected metal portions, in said gasket compartment.

In such system, the overall radial and cross width of the head 2 and of the tail 3 correspond to said prefixed depth of the gasket compartment 10.

Furthermore, the height of the compressed gasket 1 corresponds to the height of the compartment 10 so as to prevent, during compression, the deformation of the inner face of the gasket 1, and the formation of a possible discontinuity between the connected surfaces.

Advantageously, in this sealing system, the gasket 1 is made of the same material thereof the portions are made which should be connected by the gasket 1, such as copper or copper alloy, raw metal material or a material partially annealed at a maximum temperature of 350°C.

To the above-described process for implementing a metal gasket for a radio-frequency structure a person skilled in the art, with the purpose of satisfying additional and contingent needs, could introduce several additional modifications and variants, however all comprised within the protective scope of the present invention, as defined by the enclosed claims.

## Claims

1. A process for manufacturing a joint between two metal portions delineating an inner space, such junction allowing to obtain a high or ultra-high vacuum sealing and a radiofrequency contact both flush with the surface delineating the inner space, comprising the steps of:
• providing a metal gasket (1) the cross-section thereof has: a sealing head (2) with conical shape, with a flat base (4) constituting an inner face of the gasket and a conical body the upper and lower edges thereof (5, 6), adjacent to said base (4), are intended to be tightened between two metal portions therebetween a gasket compartment (10) is formed having a pre-fixed depth, and a centering tail (3) extending outwards from a vertex of said head (2) opposite to said base (4), in perpendicular direction to said base (4) for an extension so that the overall cross width of the head (2) and of the tail (3) correspond to said prefixed depth, the angle of opening (2α) of said conical shape being lower than 60° , and the head (2) and the tail (3) constituting a single body, without discontinuity, so that the gasket (1) is constituted in a single piece;
• arranging said gasket (1) in said gasket compartment (10) by resting the distal end (7) of said tail (3) onto the bottom (16) of the gasket compartment (10) so that the inner face of the gasket (1) is flush with the surfaces of the metal portions to be joined by implementing therewith a continuous surface, in the profile of said tail (3) and/or in the surface of said compartment (10) suitable discontinuities being provided, so that the areas of the compartment (10) above and below said tail (3) are in communication therebetween;
• tightening the two metal portions one against the other one by implementing the vacuum sealing and the radiofrequency contact and by interrupting the tightening before deforming the inner face of the gasket (1), so as to prevent a possible discontinuity between the joined surfaces.

2. The process according to claim 1, wherein the gasket (1) is made of the same material thereof the portions which will have to be joined by the gasket (1) are made.

3. The process according to claim 1, wherein the conical body constituting the head (3) has upper (5) and lower (6) edges with prefixed width (a), which are intended to be tightened between the two metal portions, such edges (5, 6) having flat resting portions, substantially perpendicular to said base (4), arranged at a distance representing the height (d) of the gasket (1).

4. The process according to claim 1, wherein said angular opening (2α) is comprised between 20° and 60°.

5. The process according to claim 1, wherein the centering tail (3) extends with a substantially constant thickness (t).

6. The process according to claim 1, wherein the tightening is so as to give an elastic deformation to the gasket 1, with a maximum compression comprised between 25% and 50%.

7. The process according to claim 3, wherein the width (a) of the resting surface (5, 6) has a maximum of 0.8 mm.

8. The process according to claims 3 and 5, wherein the height ((d-t)/2)) of the sealing tooth of the gasket (1), that is the distance between the tail (3) and the resting surfaces (5, 6) is comprised between 0.2 mm and 0.4 mm.

9. The process according to claim 1, wherein the maximum centering error in the coupling between gasket (1) and metal portions is comprised between 20 µm and 40 µm.

10. The process according to claim 1, wherein the gasket (1) is made of copper or copper alloy, raw material or partially annealed at a maximum temperature of 350°C.

11. A vacuum sealing metal gasket (1), apt to be inserted, at a joint, between two connected metal portions delimiting a space and with an inner face directed towards said space, the metal gasket having an annular or a linear development, wherein the cross-section of said metal gasket (1) has:
a sealing head (2) with conical shape, with a flat base (4) constituting the inner face of the gasket and a conical body, the upper and lower edges thereof (5, 6) being adjacent to said flat base (4) and intended to be tightened between the two metal portions;
wherein the upper (5) and lower (6) edges have flat resting surfaces, substantially perpendicular to said base (4), arranged at a distance representing the height (d) of the gasket (1),
**characterised in that** the cross section of said metal gasket (1) has a centering tail (3) extending from a vertex of the head (2) opposite to said flat base (4) and in a direction perpendicular to said base (4) towards outside, for a predetermined extension;
wherein the angle of opening (2α) of said conical shape being lower than 60° and
wherein the head (2) and the tail (3) constitute a single body, without discontinuity, so that the gasket (1) is constituted in a single piece;

12. The gasket (1) according to claim 11, wherein the height ((d-t)/2)) of the sealing tooth of the gasket (1), that is the distance between the tail (3) and the resting surfaces (5, 6) is comprised between 0.2 mm and 0.4 mm.

13. The gasket (1) according to claim 11, wherein said angular opening (2α) is comprised between 20° e 60°.

14. The gasket (1) according to claim 11, made of copper or copper alloy, raw metal material or a material partially annealed at a maximum temperature of 350°C.

15. A radio-frequency structure, comprising at least a vacuum sealing metal gasket according to any of claims 11 to 14.

16. The radio-frequency structure according to claim 15, apt to work as radio-frequency (RF) gun (20).

17. A high and ultra-high vacuum sealing system, comprising:
• two metal portions to be coupled, forming a space wherein a high or ultra-high vacuum level is to be determined, delimited by surfaces of said metal portions arranged so as to form a continuous surface;
• a gasket compartment (10) formed between said metal portions at said continuous surface, having a section with a prefixed height and depth;
• a metal gasket (1) of claims 11 to 14, inserted between the two connected metal portions, in said gasket compartment,
wherein the overall radial and cross width of a head (2) and of a tail (3) of the above metal gasket (1) correspond to said prefixed depth of the gasket compartment (10).

18. The high and ultra-high vacuum sealing system according to claim 17, wherein the gasket (1) is made of the same material therewith the portions are made which will have to be joined by the gasket (1).

19. The high and ultra-high vacuum sealing system according to claim 18, wherein the gasket (1) is made of copper or copper alloy, raw metal material or a material partially annealed at a maximum temperature of 350°C.

## Patentansprüche

1. Verfahren zur Herstellung einer Verbindung zwischen zwei Metallteilen, die einen Innenraum begrenzen, wobei eine solche Verbindung es ermöglicht, eine Hoch- oder Ultrahochvakuumabdichtung und einen Radiofrequenzkontakt zu erhalten, die beide plan mit der den Innenraum begrenzenden Oberfläche sind, welches die folgenden Schritte aufweist:
• Bereitstellen einer Metalldichtung (1) deren Querschnitt aufweist: einen konischen Dichtkopf (2), mit einer flachen Basis (4), die eine Innenfläche der Dichtung bildet, und einem konischen Körper, dessen Ober- und Unterkante (5, 6), die an die Basis (4) angrenzen, dazu gedacht sind, zwischen zwei Metallteilen festgemacht zu werden, zwischen denen ein Dichtungsraum (10) ausgebildet ist, mit einer voreingestellten Tiefe und einem sich von einem Scheitelpunkt des Kopfes (2) nach außen erstreckenden Zentrierende (3) gegenüber der Basis (4), in senkrechter Richtung zur Basis (4) für eine Verlängerung, so dass die Gesamtquerbreite des Kopfes (2) und des Endes (3) zu der voreingestellten Tiefe korrespondieren, wobei der Öffnungswinkel (2α) der konischen Form kleiner als 60° ist, und wobei der Kopf (2) und das Ende (3) einen einzigen Körper bilden, ohne Diskontinuität, so dass die Dichtung (1) in einem einzigen Stück gebildet ist;
• Anordnen der Dichtung (1) in dem Dichtungsraum (10) durch Auflegen des distalen Endes (7) von dem Ende (3) auf den Boden (16) des Dichtungsraums (10), so dass die Innenfläche der Dichtung (10) 1) plan ist mit den Flächen der zu verbindenden Metallteile, indem damit eine durchgehende Fläche implementiert wird, wobei in dem Profil des Endes (3) und/oder in der Fläche des Raums (10) geeignete Diskontinuitäten bereitgestellt sind, so dass die Bereiche des Raums (10) über und unter dem Ende (3) dazwischen in Verbindung stehen;
• Festmachen beiden Metallteile eines gegen das andere durch Implementierung der Vakuumabdichtung und des Radiofrequenzkontakts und durch Unterbrechung der Abdichtung vor einer Deformierung der Innenfläche der Dichtung (1), um eine mögliche Diskontinuität zwischen den verbundenen Flächen zu vermeiden.

2. Verfahren nach Anspruch 1, wobei die Dichtung (1) aus dem gleichen Material hergestellt ist, aus dem die Teile hergestellt sind, die durch die Dichtung (1) verbunden werden müssen.

3. Verfahren nach Anspruch 1, wobei der den Kopf (3) bildende konische Körper obere (5) und untere (6) Kanten mit voreingestellter Breite (a) aufweist, die dazu bestimmt sind, zwischen den beiden Metallteilen festgemacht zu werden, wobei solche Kanten (5, 6), die flache Auflageabschnitte aufweisen, im Wesentlichen senkrecht zu der Basis (4), in einem Abstand angeordnet sind, der die Höhe (d) der Dichtung (1) darstellt.

4. Verfahren nach Anspruch 1, wobei die Winkelöffnung (2α) zwischen 20 ° und 60° liegt.

5. Verfahren nach Anspruch 1, wobei sich das Zentrierende (3) mit einer im Wesentlichen konstanten Dicke (t) erstreckt.

6. Verfahren nach Anspruch 1, wobei das Festmachen so ist, dass die Dichtung (1) eine elastische Verformung erhält, wobei eine maximale Kompression zwischen 25% und 50% liegt.

7. Verfahren nach Anspruch 3, wobei die Breite (a) der Auflagefläche (5, 6) ein Maximum von 0.8 mm hat.

8. Verfahren nach den Ansprüchen 3 und 5, wobei die Höhe ((d-t)/2)) des Abdichtzahns der Dichtung (1), das heißt der Abstand zwischen dem Ende (3) und den Auflageflächen (5, 6), zwischen 0.2 mm und 0.4 mm liegt.

9. Verfahren nach Anspruch 1, wobei der maximale Zentrierungsfehler in der Kopplung zwischen Dichtung (1) und Metallteilen zwischen 20 µm und 40 µm liegt.

10. Verfahren nach Anspruch 1, wobei die Dichtung (1) aus Kupfer oder Kupferlegierung, Rohmaterial oder teilweise geglüht bei einer Maximaltemperatur von 350 °C hergestellt ist.

11. Vakuumabdichtungs-Metalldichtung (1), die geeignet ist, zwischen zwei verbundenen Metallteilen an einer Verbindungsstelle eingesetzt zu werden, die einen Raum begrenzen und mit einer Innenfläche, die auf den Raum gerichtet ist, wobei die Metalldichtung eine ringförmige oder lineare Ausdehnung aufweist, wobei der Querschnitt der Metalldichtung aufweist:
einen Abdichtungskopf (2) mit konischer Form, wobei eine flache Basis (4) die Innenfläche der Dichtung bildet und ein konischer Körper, dessen Ober- und Unterkante (5, 6) benachbart zu der flachen Basis (4) sind und dazu gedacht ist, zwischen den beiden Metallteilen festgemacht zu werden;
wobei die oberen (5) und unteren (6) Kanten flache Auflageflächen aufweisen, die im Wesentlichen senkrecht zu der Basis (4) sind und in einem Abstand angeordnet sind, der die Höhe (d) der Dichtung (1) repräsentiert,
**dadurch gekennzeichnet,**
**dass** der Querschnitt der Metalldichtung (1) ein Zentrierende (3) aufweist, das sich von einem Scheitelpunkt des Kopfes (2) gegenüber der flachen Basis (4) und in einer Richtung senkrecht zu der Basis (4) in Richtung nach außen erstreckt, für eine vorbestimmte Erstreckung;
wobei der Öffnungswinkel (2α) der konischen Form kleiner als 60° ist; und
wobei der Kopf (2) und das Ende (3) einen einzigen Körper bilden, ohne Diskontinuität, so dass die Dichtung (1) in einem einzigen Stück gebildet ist.

12. Dichtung (1) nach Anspruch 11, wobei die Höhe ((d-t)/2)) des Abdichtzahns der Dichtung (1), das heißt der Abstand zwischen dem Ende (3) und den Auflageflächen (5, 6), zwischen 0.2 mm und 0.4 mm liegt.

13. Dichtung (1) nach Anspruch 11, wobei die Winkelöffnung (2α) zwischen 20° und 60° liegt.

14. Dichtung (1) nach Anspruch 11, hergestellt aus Kupfer oder Kupferlegierung, Rohmetallmaterial oder einem teilweise bei einer Maximaltemperatur von 350 °C geglühten Material.

15. Radiofrequenzstruktur, aufweisend mindestens eine Vakuumabdichtungs-Metalldichtung nach einem der Ansprüche 11 bis 14.

16. Hochfrequenzstruktur nach Anspruch 15, die geeignet ist, um als Hochfrequenzkanone (RF) (20) zu arbeiten.

17. Hoch- und Ultrahochvakuum-Abdichtungssystem, aufweisend:
• zwei zu koppelnde Metallteile, die einen Raum bilden, in dem ein Hoch- oder Ultrahoch-Vakuumlevel zu bestimmen ist, begrenzt durch Flächen der Metallteile, die so angeordnet sind, dass sie eine durchgehende Fläche bilden;
• einen Dichtungsraum (10), der zwischen den Metallteilen an der durchgehenden Fläche ausgebildet ist und einen Abschnitt mit einer voreingestellten Höhe und Tiefe aufweist;
• eine Metalldichtung (1) nach den Ansprüchen 11 bis 14, die zwischen den beiden verbundenen Metallteilen in den Dichtungsraum eingesetzt ist,
wobei die gesamte radiale und Querbreite eines Kopfes (2) und eines Endes (3) der obigen Metalldichtung (1) zu der voreingestellten Tiefe des Dichtungsraums (10) korrespondieren.

18. Hoch- und Ultrahochvakuum-Abdichtungssystem nach Anspruch 17, wobei die Dichtung (1) aus dem gleichen Material hergestellt ist, aus dem die Teile hergestellt sind, die durch die Dichtung (1) verbunden werden müssen.

19. Hoch- und Ultrahochvakuum-Abdichtungssystem nach Anspruch 18, wobei die Dichtung (1) aus Kupfer oder Kupferlegierung, Rohmetallmaterial oder einem teilweise bei einer Maximaltemperatur von 350 °C geglühten Material besteht.

## Revendications

1. Procédé pour fabriquer un joint entre deux portions métalliques bornant un espace intérieur, une telle jonction permettant d'obtenir une étanchéité à vide élevé ou ultra-élevé et un contact radiofréquence les deux dans l'alignement de la surface bornant l'espace intérieur, comprenant les étapes consistant à :
- prévoir une bague d'étanchéité (1) métallique dont la section transversale a : une tête (2) d'étanchéité avec une forme conique, avec une base (4) plate constituant une face intérieure de la bague d'étanchéité et un corps conique dont les bords supérieur et inférieur (5, 6), adjacents à ladite base (4), sont destinés à être serrés entre deux portions métalliques entre lesquelles un compartiment (10) de bague d'étanchéité est formé ayant une profondeur fixée au préalable, et une queue (3) de centrage s'étendant vers l'extérieur à partir d'un sommet de ladite tête (2) opposé à ladite base (4), dans une direction perpendiculaire par rapport à ladite base (4) pour une extension de façon à ce que la largeur transversale globale de la tête (2) et de la queue (3) correspondent à ladite profondeur fixée au préalable, l'angle d'ouverture (2α) de ladite forme conique étant inférieur à 60°, et la tête (2) et la queue (3) constituant un seul corps, sans discontinuité, de façon à ce que la bague d'étanchéité (1) soit constituée dans une seule pièce ;
- agencer ladite bague d'étanchéité (1) dans ledit compartiment (10) de bague d'étanchéité en appuyant l'extrémité distale (7) de ladite queue (3) sur le fond (16) du compartiment (10) de bague d'étanchéité de façon à ce que la face intérieure de la bague d'étanchéité (1) soit dans l'alignement des surfaces des portions métalliques devant être jointes en mettant en œuvre avec celles-ci une surface continue, dans le profil de ladite queue (3) et/ou dans la surface dudit compartiment (10) des discontinuités adaptées étant prévues, de façon à ce que les zones du compartiment (10) au-dessus et en dessous de ladite queue (3) soient en communication entre elles ;
- serrer les deux portions métalliques l'une contre l'autre en mettant en œuvre l'étanchéité à vide et le contact radiofréquence et en interrompant le serrage avant de déformer la face intérieure de la bague d'étanchéité (1), de façon à empêcher une discontinuité possible entre les surfaces jointes.

2. Procédé selon la revendication 1, dans lequel la bague d'étanchéité (1) est faite de la même matière que celle dont les portions qui devront être jointes par la bague d'étanchéité (1) sont faites.

3. Procédé selon la revendication 1, dans lequel le corps conique constituant la tête (2) a des bords supérieur (5) et inférieur (6) avec une largeur (a) fixée au préalable, qui sont destinés à être serrés entre les deux portions métalliques, de tels bords (5, 6) ayant des portions d'appui plates, sensiblement perpendiculaires à ladite base (4), agencées à une distance représentant la hauteur (d) de la bague d'étanchéité (1).

4. Procédé selon la revendication 1, dans lequel ladite ouverture angulaire (2α) est comprise entre 20° et 60°.

5. Procédé selon la revendication 1, dans lequel la queue (3) de centrage s'étend avec une épaisseur (t) sensiblement constante.

6. Procédé selon la revendication 1, dans lequel le serrage est de façon à donner une déformation élastique à la bague d'étanchéité (1), avec une compression maximale comprise entre 25 % et 50 %.

7. Procédé selon la revendication 3, dans lequel la largeur (a) de la surface d'appui (5, 6) a un maximum de 0,8 mm.

8. Procédé selon les revendications 3 et 5, dans lequel la hauteur ((d - t)/2)) de la dent d'étanchéité de la bague d'étanchéité (1), qui est la distance entre la queue (3) et les surfaces d'appui (5, 6) est comprise entre 0,2 mm et 0,4 mm.

9. Procédé selon la revendication 1, dans lequel l'erreur de centrage maximale dans l'accouplement entre une bague d'étanchéité (1) et des portions métalliques est comprise entre 20 µm et 40 µm.

10. Procédé selon la revendication 1, dans lequel la bague d'étanchéité (1) est faite de cuivre ou d'alliage de cuivre, d'une matière première ou partiellement recuite à une température maximale de 350 °C.

11. Bague d'étanchéité (1) métallique d'étanchéité à vide, appropriée pour être insérée, au niveau d'un joint, entre deux portions métalliques reliées délimitant un espace et avec une face intérieure dirigée vers ledit espace, la bague d'étanchéité métallique ayant un développement annulaire ou linéaire, dans laquelle la section transversale de ladite bague d'étanchéité (1) métallique a :
une tête (2) d'étanchéité avec une forme conique, avec une base (4) plate constituant la face intérieure de la bague d'étanchéité et un corps conique, les bords supérieur et inférieur (5, 6) de celle-ci étant adjacents à ladite base (4) plate et destinés à être serrés entre les deux portions métalliques ;
dans laquelle les bords supérieur (5) et inférieur (6) ont des surfaces d'appui plates, sensiblement perpendiculaires à ladite base (4), agencées à une distance représentant la hauteur (d) de la bague d'étanchéité (1),
**caractérisée en ce que** la section transversale de ladite bague d'étanchéité (1) métallique a une queue (3) de centrage s'étendant à partir d'un sommet de la tête (2) opposé à ladite base (4) plate et dans une direction perpendiculaire à ladite base (4) vers l'extérieur, pour une extension prédéterminée ;
dans laquelle l'angle d'ouverture (2α) de ladite forme conique étant inférieur à 60°, et
dans laquelle la tête (2) et la queue (3) constituent un seul corps, sans discontinuité, de façon à ce que la bague d'étanchéité (1) soit constituée dans une seule pièce.

12. Bague d'étanchéité (1) selon la revendication 11, dans laquelle la hauteur ((d - t)/2)) de la dent d'étanchéité de la bague d'étanchéité (1), qui est la distance entre la queue (3) et les surfaces d'appui (5, 6) est comprise entre 0,2 mm et 0,4 mm.

13. Bague d'étanchéité (1) selon la revendication 11, dans laquelle ladite ouverture angulaire (2α) est comprise entre 20° et 60°.

14. Bague d'étanchéité (1) selon la revendication 11, faite de cuivre ou d'alliage de cuivre, d'une matière première métallique ou d'une matière partiellement recuite à une température maximale de 350 °C.

15. Structure radiofréquence, comprenant au moins une bague d'étanchéité métallique d'étanchéité à vide selon l'une quelconque des revendications 11 à 14.

16. Structure radiofréquence selon la revendication 15, appropriée pour fonctionner comme un canon radiofréquence (RF) (20).

17. Système d'étanchéité à vide élevé et ultra-élevé, comprenant :
- deux portions métalliques devant être accouplées, formant un espace dans lequel un niveau de vide élevé ou ultra-élevé doit être déterminé, délimité par des surfaces desdites portions métalliques agencées de façon à former une surface continue ;
- un compartiment (10) de bague d'étanchéité formé entre lesdites portions métalliques au niveau de ladite surface continue, ayant une section avec une hauteur et une profondeur fixées au préalable ;
- une bague d'étanchéité (1) métallique selon les revendications 11 à 14, insérée entre les deux portions métalliques reliées, dans ledit compartiment de bague d'étanchéité,
dans lequel la largeur radiale et transversale globale d'une tête (2) et d'une queue (3) de la bague d'étanchéité (1) métallique ci-dessus correspondent à ladite profondeur fixée au préalable du compartiment (10) de bague d'étanchéité.

18. Système d'étanchéité à vide élevé et ultra-élevé selon la revendication 17, dans lequel la bague d'étanchéité (1) est faite de la même matière que celle dont les portions sont faites qui devront être jointes par la bague d'étanchéité (1).

19. Système d'étanchéité à vide élevé et ultra-élevé selon la revendication 18, dans lequel la bague d'étanchéité (1) est faite de cuivre ou d'alliage de cuivre, d'une matière première métallique ou d'une matière partiellement recuite à une température maximale de 350 °C.
